# EUROPÄISCHE PATENTSCHRIFT

(11) **EP 2 943 368 B1**
(45) Veröffentlichungstag und Bekanntmachung des Hinweises auf die Patenterteilung: **04.04.2018**
(21) Anmeldenummer: 14700465.9
(22) Anmeldetag: 13.01.2014
(51) Int. Cl.: B60K 37/06, B60Q 1/00, G06F 3/0354, H03K 17/96, H01H 3/02

(54) **BEDIENEINRICHTUNG, FAHRZEUGLENKRAD SOWIE VERFAHREN ZUM BETRIEB EINER BEDIENEINRICHTUNG**
CONTROL DEVICE, VEHICLE STEERING WHEEL AND METHOD FOR OPERATING A CONTROL DEVICE
DISPOSITIF DE COMMANDE, VOLANT DE VÉHICULE ET PROCÉDÉ POUR FAIRE FONCTIONNER UN DISPOSITIF DE COMMANDE

(30) Priorität: 14.01.2013 DE 102013100355
(43) Veröffentlichungstag der Anmeldung: 18.11.2015
(73) Patentinhaber: TRW Automotive Electronics & Components GmbH, 78315 Radolfzell (DE)
(72) Erfinder: KOCH, Frank, 88048 Friedrichshafen (DE); KORHERR, Joachim, 78359 Orsingen (DE)
(74) Vertreter: Prinz & Partner mbB
(86) Internationale Anmeldenummer: PCT/EP2014/050472
(87) Internationale Veröffentlichungsnummer: WO 2014/108533

(56) Entgegenhaltungen:
- US-A1- 2007 119 698
- US-A1- 2009 140 994
- US-A1- 2012 161 795

## Beschreibung

Die Erfindung betrifft eine Bedieneinrichtung für ein Fahrzeuglenkrad, ein Fahrzeuglenkrad sowie ein Verfahren zum Betrieb einer Bedieneinrichtung für ein Fahrzeuglenkrad.

Im Automobilbereich werden viele Fahrzeugfunktionen aber auch Multimediaanwendungen, beispielsweise Radio, Musik oder Telefon, über Taster oder Bedienfelder gesteuert, die so am Fahrzeuglenkrad angeordnet, dass der Fahrzeuginsasse diese, ohne das Fahrzeuglenkrad loslassen zu müssen, bedienen kann. Die Anzahl der Anwendungen, die über solche Bedieneinrichtungen gesteuert werden sollen, nimmt allerdings immer mehr zu. Aufgrund des Platzangebotes und aus Gründen der Übersichtlichkeit kann die Anzahl der Schalter und Taster am Fahrzeuglenkrad aber nicht beliebig erhöht werden. Zudem muss eine unbeabsichtigte Bedienung bzw. eine Fehlbedienung der Bedieneinrichtungen verhindert werden.

Aus dem Stand der Technik sind beispielsweise Bedienfelder mit mehreren Tasten bekannt, wobei die Tasten Mehrfachbelegungen aufweisen können. Das heißt durch Betätigen eines Umschalters können verschiedene Funktionen mit einem Taster bedient werden. Aus optischen Gründen ist es aber nicht erwünscht, dass zu viele Tasten am Lenkrad angeordnet sind. Zudem ist die Lagerung der Bedienfläche solcher Tasten sehr aufwendig und es ist eine Mindestgröße für die Tasten erforderlich, um diese zu bedienen. Des Weiteren sind berührungsempfindliche Sensorflächen bekannt, über die mehrere Fahrzeugfunktionen bedient werden können.

In der US 2009/0140994 A1 ist eine Bedieneinrichtung für ein Fahrzeug, mit einer Sensorfläche und einem darunter angeordneten mechanischen Schaltelement gezeigt. Die Sensorfläche ist auf einem schwenkbaren Träger angeordnet, wobei durch Schwenken des Trägers das mechanische Schaltelement betätigt werden kann.

Die US 2007/0119698 A1 zeigt ein Bedienelement für ein elektronisches Gerät. Das Bedienelement weist eine berührungsempfindliche Sensorfläche auf, unter der mehrere mechanische Schaltelemente vorgesehen sind, die durch Eindrücken der Sensorfläche betätigt werden können.

Aufgabe der Erfindung ist es, eine Bedieneinrichtung für ein Fahrzeuglenkrad sowie ein Fahrzeuglenkrad bereitzustellen, das eine einfachere Bedienung einer Vielzahl von Fahrzeugfunktionen ermöglicht. Aufgabe der Erfindung ist es des Weiteren ein Verfahren zum Betrieb eines solchen Bedienelements bereitzustellen.

Zur Lösung der Aufgabe ist eine Bedieneinrichtung für ein Fahrzeuglenkrad vorgesehen, mit einer geschlossenen, berührungsempfindlichen, vorzugsweise dreidimensional geformten Sensorfläche, und mit zumindest zwei mechanischen Schaltelementen, die unter der Sensorfläche angeordnet sind und durch Verformen der Sensorfläche betätigt werden können. Die berührungsempfindliche Sensorfläche ist so flexibel ausgebildet, dass die mechanischen Schaltelemente einzeln betätigt werden können. Des Weiteren ist ein Umschalter vorgesehen, der die mechanischen Schaltelemente und/oder die berührungsempfindliche Sensorfläche aktivieren und/oder deaktivieren kann. Erfindungsgemäß sind die Schaltelemente und die Sensorfläche nicht nebeneinander vorgesehen, sondern die Schaltelemente sind unterhalb der Sensorfläche angeordnet. Wird die berührungsempfindliche Sensorfläche deaktiviert, können aufgrund der Flexibilität der Sensorfläche die darunterliegenden mechanischen Schaltelemente einzeln bedient werden. Optional können auch die mechanischen Schaltelemente deaktiviert werden, sodass nur über eine Berührung der Sensorfläche Funktionen gesteuert werden können.

Die Sensorfläche kann eben ausgebildet sein, es ist aber auch denkbar, dass diese dreidimensional vorgeformt ist, sodass beispielsweise die Position der darunterliegenden Schaltelemente ertastet werden kann. Dadurch wird der Fahrzeuginsasse beim Bedienen der Bedieneinrichtung wesentlich weniger abgelenkt und kann sich auf den Verkehr konzentrieren. Durch die dreidimensionale Form kann die Sensorfläche aber auch an die Oberfläche des Fahrzeuglenkrades angepasst werden, so dass die Sensorfläche nicht von dieser vorsteht. Da die Sensorfläche geschlossen ist, ist zudem eine einfachere Reinigung des Fahrzeuglenkrades sichergestellt und eine Verschmutzung der mechanischen Schaltelemente zuverlässig verhindert.

Die mechanischen Schaltelemente sind beispielsweise elektrische Kurzhubschalter, die mit einem sehr geringen Auslöseweg aktiviert oder deaktiviert werden können. Dadurch ist nur ein geringes Eindrücken der Sensorfläche erforderlich, sodass diese steifer ausgebildet werden kann, um die Haptik des Fahrzeuglenkrades zu verbessern. Zudem ist durch den geringen Bedienweg eine Beschädigung der Sensorfläche zuverlässig verhindert.

Um die Schaltelemente exakt bedienen zu können, sind auf der Rückseite der Sensorfläche beispielsweise Betätigungselemente vorgesehen, die die Kurzhubschalter betätigen. Kurzhubschalter weisen relativ kleine Abmessungen auf, so dass es schwierig ist, diese exakt zu bedienen. Die Betätigungselemente können eine größere Fläche aufweisen sowie einen Bedienvorsprung, der am Kurzhubschalter anliegt, wodurch auf der Sensorfläche ein größerer Bereich zur Verfügung steht, um das jeweilige mechanische Schaltelement zu bedienen.

Vorzugsweise ist die Sensorfläche zumindest abschnittsweise transparent oder transluzent ausgebildet, und es zumindest eine Lichtquelle, insbesondere eine Leuchtdiode vorgesehen, die die Sensorfläche rückseitig beleuchten kann. Durch eine entsprechende Beleuchtung können beispielsweise einzelne Bereiche hervorgehoben werden, über die bei einer ebenen Ausführung der Sensorfläche die Schaltelemente bzw. die Betätigungselemente markiert werden. Es ist aber auch denkbar, dass durch die Beleuchtung einzelne Bereiche der Sensorfläche hervorgehoben werden. Insbesondere können die Betätigungselemente ebenfalls transparent ausgebildet sein, sodass die Lichtquelle durch diese hindurch die Rückseite der Sensoroberfläche beleuchten kann.

Die Sensorfläche kann beispielsweise eine kapazitiv berührungssensitive Sensorfläche sein, sodass ein einfaches Eingeben durch Berühren der Sensorfläche erfolgen kann.

Erfindungsgemäß ist des Weiteren ein Fahrzeuglenkrad mit einer solchen Bedieneinrichtung vorgesehen, wobei die Bedieneinrichtung im Bereich der Lenkradspeichen und/oder des Lenkradkranzes vorgesehen ist. Vorzugsweise ist die Bedieneinrichtung so angeordnet, dass diese bedient werden kann, ohne dass der Fahrzeuginsasse die Position der Hände am Lenkrad verändern muss. Die Bedieneinrichtung ist aus diesem Grund vorzugsweise im radial äußeren Bereich der Lenkradspeichen vorgesehen. Somit ist eine Bedienung beispielsweise mit dem Daumen möglich, ohne dass der Fahrzeuginsasse das Lenkrad loslassen muss.

Der Umschalter kann getrennt von der Sensorfläche und den mechanischen Schaltelementen am Fahrzeuglenkrad angeordnet sein, sodass eine einfachere Bedienung des Umschalters möglich ist. Der Umschalter kann beispielsweise so angeordnet sein, dass er mit einer Hand bedient werden kann, während die Sensorfläche und die darunterliegenden mechanischen Schaltelemente so angeordnet sind, dass diese mit der anderen Hand bedient werden können.

Der Umschalter und die Sensorfläche mit den mechanischen Schaltelementen können dazu beispielsweise in Umfangsrichtung versetzt am Fahrzeuglenkrad angeordnet sein.

Der Umschalter kann an einer ersten Lenkradspeiche angeordnet sein und die Sensorfläche sowie die mechanischen Schaltelemente an einer zweiten Lenkradspeiche. Die Lenkradspeichen ermöglichen dem Fahrzeuginsassen zusätzlich eine leichtere Orientierung, sodass die Bedieneinrichtung einfach gefunden und bedient werden kann, wodurch eine Ablenkung des Fahrzeuginsassen verhindert und die Bedienung erleichtert wird.

Erfindungsgemäß ist des Weiteren ein Verfahren zum Betrieb eines erfindungsgemäßen Bedienelements vorgesehen, wobei wahlweise die Sensorfläche und/oder die mechanischen Schaltelemente durch Betätigen des Umschalters deaktiviert werden, sodass eine gezielte Bedienung entweder nur der Schaltelemente oder nur der Sensorfläche möglich ist.

Die Aktivierung oder Deaktivierung der Schaltelemente oder der Sensorfläche kann beispielsweise zeitabhängig, funktionsabhängig oder manuell aufgehoben werden. Es ist beispielsweise denkbar, dass die Sensorfläche über den Umschalter aktiviert wird, um eine gewünschte Funktion über die Sensorfläche zu steuern und nach Eingabe und Erkennen der Eingabe die Sensorfläche automatisch wieder deaktiviert wird, um eine weitere, gegebenenfalls falsche Eingabe zu verhindern. Es ist auch denkbar, dass dem Fahrzeuginsassen nach Aktivierung der Sensorfläche ein Zeitfenster zur Verfügung steht, innerhalb dessen eine Eingabe erfolgen muss. Eine Deaktivierung kann aber auch manuell durch den Umschalter oder eine bestimmte Bedienung der Sensorfläche erfolgen.

Weitere Vorteile und Merkmale ergeben sich aus der nachfolgenden Beschreibung in Verbindung mit den beigefügten Zeichnungen. In diesen zeigen:
- Figur 1 ein erfindungsgemäßes Fahrzeuglenkrad, und
- Figur 2 eine Teilschnittansicht durch eine Bedieneinrichtung für das Fahrzeuglenkrad aus Figur 1.

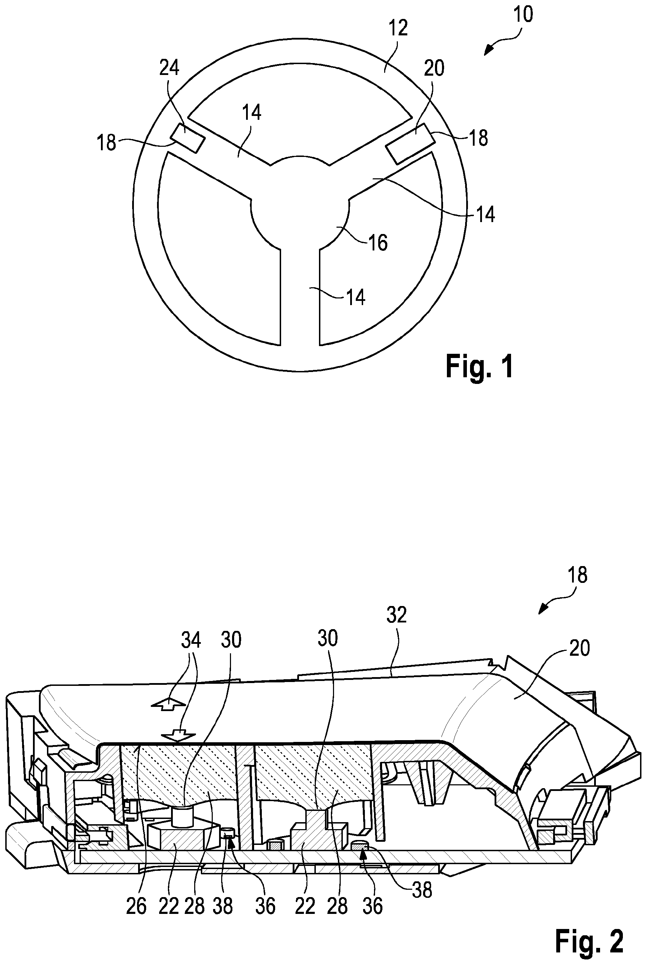

In Figur 1 ist ein Fahrzeuglenkrad 10 mit einem Lenkradkranz 12 sowie drei Speichen 14 gezeigt, mit welchen der Lenkradkranz 12 an einer Lenkradnabe 16 gehalten ist.

An zwei der Speichen 14 ist eine zweigeteilte Bedieneinrichtung 18 vorgesehen. An der ersten Speiche 14 ein Umschalter 24 der Bedieneinrichtung 18 angeordnet, an der zweiten Speiche 14 ist eine berührungsempfindliche Sensorfläche 20 angeordnet, deren Oberfläche 30 geschlossen ist.

Vorzugsweise ist die Sensorfläche 20 kapazitiv berührungssensitiv, sodass diese auch leichte Berührungen des Fahrzeuginsassen registrieren kann. Des Weiteren ist die Sensorfläche 20 in der hier gezeigten Ausführungsform teilweise transparent bzw. transluzent und flexibel ausgebildet.

Wie insbesondere in Figur 2 zu sehen ist, sind unter der Sensorfläche 20 mehrere mechanische Schaltelemente 22 angeordnet, die in der hier gezeigten Ausführungsform Kurzhubschalter sind.

Auf der Rückseite 26 der Sensorfläche 20 sind im Bereich der mechanischen Schaltelemente 22 jeweils Betätigungselemente 28 vorgesehen. Die Betätigungselemente 28 liegen flächig an der Rückseite 26 der Sensorfläche 20 an und sind insbesondere stoffschlüssig mit dieser verbunden. Des Weiteren weisen die Betätigungselemente 28 jeweils einen Vorsprung 30 auf, der an den Kurzhubschalters bzw. den mechanischen Schaltelementen 22 anliegt, so dass bei einem punktuellen Eindrücken der Sensorfläche im Bereich der Betätigungselemente 28 eine Betätigung des jeweiligen mechanischen Schaltelements 22 erfolgt.

Auf der Oberfläche 32 der Sensorfläche 20 sind Symbole 34 vorgesehen, die die Position der Betätigungselemente 28 bzw. der darunterliegenden mechanischen Schaltelemente 22 kennzeichnen.

Auf der Rückseite 26 der Sensorfläche 20 sind des Weiteren mehrere Lichtquellen 36 vorgesehen, die jeweils eine Leuchtdiode 38 aufweisen. Durch die Lichtquellen 36 ist eine rückseitige Beleuchtung der Sensorfläche 20 möglich. Die Sensorfläche 20 sowie die Betätigungselemente 28 sind vorzugsweise transparent oder transluzent ausgebildet, sodass durch die Lichtquellen 36 Bereiche auf der Oberfläche 32 der Sensorfläche 20 beleuchtet und/oder gekennzeichnet werden können.

Die Sensorfläche 20 ist flexibel ausgebildet, sodass diese durch einen stärkeren Druck auf die Sensorfläche 20 verformt werden kann, wodurch die Betätigungselemente 28 in Richtung der mechanischen Schaltelemente 22 verschoben werden und diese betätigen können.

Durch den an der zweiten Speiche 14 vorgesehenen Umschalter 24 können die mechanischen Schaltelemente 22 und/oder die berührungsempfindliche Sensorfläche 20 wahlweise deaktiviert bzw. aktiviert werden. Des Weiteren kann durch den Umschalter 24 zwischen verschiedenen Bedienebenen der mechanischen Schaltelemente 22 und der Sensorfläche 20 umgeschaltet werden.

Dadurch die Bedienung bzw. die Eingabe von verschiedenen Fahrzeugfunktionen möglich.

Um die Schaltelemente 22 zu bedienen, wird beispielsweise die Sensorfläche 20 deaktiviert, sodass durch Verformen bzw. Eindrücken der Sensorfläche 20 nur die mechanischen Schaltelemente 22 bedient werden.

Um andere Funktionen zu bedienen, für die die Sensorfläche 22 erforderlich ist, kann die Sensorfläche 20 aktiviert werden, sodass durch leichte Berührung der Oberfläche 32 eine Eingabe möglich ist. Optional können gleichzeitig die darunterliegenden Schaltelemente 22 deaktiviert werden, um ein versehentliches Bedienen der Schaltelemente 22 auszuschließen.

Durch die Lichtquelle 36 kann der jeweilige Bereich der Sensorfläche 20, der für eine Eingabe oder eine Betätigung der Schaltelemente 22 oder der Sensorfläche einzudrücken oder zu berühren ist, beleuchtet oder markiert werden. Die Lichtquellen 36 können beispielsweise so angesteuert bzw. mit dem Umschalter 24 gekoppelt sein, dass beispielsweise die Beleuchtung der Symbole 34 nur erfolgt, wenn die mechanischen Schaltelemente 22 aktiviert sind.

Vorzugsweise kann in die Sensorfläche 20 auch ein Display integriert sein, durch das Bedienbereiche der Sensorfläche 20 markiert werden.

Die Oberfläche 32 der Sensorfläche 20 kann auch dreidimensional vorgeformt sein, sodass diese an die Form des Fahrzeuglenkrads 10 angepasst ist. Alternativ können dadurch auf der Oberfläche 32 der Sensorfläche 20 Bereiche markiert werden, so dass diese einfacher ertastet werden können.

Ein Deaktivieren der Sensorfläche 20 bzw. der Schaltelemente 22 nach Betätigen der Funktion kann durch den Umschalter 24 erfolgen. Ein anschließendes Deaktivieren kann beispielsweise aber auch in Abhängigkeit von den eingegebenen Gesten oder Funktionen erfolgen, so dass beispielsweise nach dem Identifizieren einer vollständigen Eingabe die Sensorfläche 20 oder die Schaltelemente 22 aktiviert oder deaktiviert werden, um eine weitere Eingabe zu verhindern. Alternativ kann die Deaktivierung auch zeitabhängig erfolgen, so dass dem Fahrzeuginsasse ein definiertes Zeitfenster zur Eingabe zur Verfügung steht.

Idealerweise ist die Bedieneinrichtung bestehend aus der Sensorfläche 20 mit den darunterliegenden Schaltelementen 22 sowie dem Umschalter 24 im radial äußeren Bereich der Lenkradspeichen 14 oder am Lenkradkranz 12 angeordnet, sodass eine Bedienung durch den Fahrzeuginsassen möglich ist, ohne das Fahrzeuglenkrad loszulassen.

## Patentansprüche

1. Bedieneinrichtung für ein Fahrzeuglenkrad (10), mit einer geschlossenen, berührungsempfindlichen, vorzugsweise dreidimensional geformten Sensorfläche (20), zumindest zwei mechanischen Schaltelementen (22), die unter der Sensorfläche (20) angeordnet sind und durch Verformen der Sensorfläche (20) betätigt werden können, wobei die berührungsempfindliche Sensorfläche (20) so flexibel ausgebildet ist, dass die mechanischen Schaltelemente (22) einzeln betätigt werden können, und mit einem Umschalter (24), der die mechanischen Schaltelemente (22) und/oder die berührungsempfindliche Sensorfläche (20) aktiveren und/oder deaktivieren kann.

2. Bedieneinrichtung nach Anspruch 1, **dadurch gekennzeichnet, dass** die mechanischen Schaltelemente (22) elektrische Kurzhubschalter sind.

3. Bedieneinrichtung nach einem der Ansprüche 1 oder 2, **dadurch gekennzeichnet, dass** an der Rückseite (26) der Sensorfläche (20) Betätigungselemente (28) vorgesehen sind, die die mechanischen Schaltelemente (22) betätigen.

4. Bedieneinrichtung nach einem der vorhergehenden Ansprüche, **dadurch gekennzeichnet, dass** die Sensorfläche (20) zumindest abschnittsweise transparent oder transluzent ausgebildet ist und zumindest eine Lichtquelle (36), insbesondere eine Leuchtdiode (38), vorgesehen ist, die die Sensorfläche (20) rückseitig beleuchten kann.

5. Bedieneinrichtung nach einem der vorhergehenden Ansprüche, **dadurch gekennzeichnet, dass** die berührungsempfindliche Sensorfläche (20) kapazitiv berührungssensitiv ist.

6. Fahrzeuglenkrad (10) mit einer Bedieneinrichtung nach einem der vorhergehenden Ansprüche, **dadurch gekennzeichnet, dass** die Bedieneinrichtung im Bereich der Lenkradspeichen (14) und/oder des Lenkradkranzes (12) angeordnet sind.

7. Fahrzeuglenkrad nach Anspruch 5, **dadurch gekennzeichnet, dass** der Umschalter (24) getrennt von der Sensorfläche (20) und den mechanischen Schaltelementen (22) am Fahrzeuglenkrad (10) angeordnet ist.

8. Fahrzeuglenkrad nach Anspruch 6, **dadurch gekennzeichnet, dass** der Umschalter (24) und die Sensorfläche (20) mit den mechanischen Schaltelementen (22) in Umfangsrichtung (U) versetzt am Fahrzeuglenkrad (10) angeordnet sind.

9. Fahrzeuglenkrad nach einem der Ansprüche 7 und 8, **dadurch gekennzeichnet, dass** der Umschalter (24) an einer ersten Lenkradspeiche (14) angeordnet ist und die Sensorfläche (20) sowie die mechanischen Schaltelemente (22) an einer zweiten Lenkradspeiche (14) angeordnet sind.

10. Verfahren zum Betrieb eines Bedienelements nach einem der Ansprüche 1 bis 5, **dadurch gekennzeichnet, dass** wahlweise die Sensorfläche (20) und die mechanischen Schaltelemente (22) durch Betätigen des Umschalters (24) deaktiviert werden.

11. Verfahren nach Anspruch 10, **dadurch gekennzeichnet, dass** die Deaktivierung zeitabhängig, funktionsabhängig oder manuell aufgehoben werden kann.

## Claims

1. A control device for a vehicle steering wheel (10), comprising a closed, touch-sensitive, preferably three-dimensionally shaped sensor surface (20), at least two mechanical switching elements (22) which are arranged below the sensor surface (20) and can be actuated by deforming the sensor surface (20), the touch-sensitive sensor surface (20) being designed to be so flexible that the mechanical switching elements (22) can be actuated separately, and a change-over switch (24) which can activate and/or deactivate the mechanical switching elements (22) and/or the touch-sensitive sensor surface (20).

2. The control device according to claim 1, **characterized in that** the mechanical switching elements (22) are electrical short-stroke switches.

3. The control device according to either of claims 1 or 2, **characterized in that** actuating elements (28) which actuate the mechanical switching elements (22) are provided on the rear side (26) of the sensor surface (20).

4. The control device according to any of the preceding claims, **characterized in that** the sensor surface (20) is configured to be at least partially transparent or translucent, and **in that** at least one light source (36), in particular a light-emitting diode (38), is provided which can illuminate the sensor surface (20) on the rear side.

5. The control device according to any of the preceding claims, **characterized in that** the touch-sensitive sensor surface (20) is capacitively touch-sensitive.

6. A vehicle steering wheel (10) comprising a control device according to any of the preceding claims, **characterized in that** the control device is arranged in the region of the steering wheel spokes (14) and/or the steering wheel rim (12).

7. The vehicle steering wheel according to claim 5, **characterized in that** the change-over switch (24) is arranged on the vehicle steering wheel (10) spaced apart from the sensor surface (20) and the mechanical switching elements (22).

8. The vehicle steering wheel according to claim 6, **characterized in that** the change-over switch (24) and the sensor surface (20) with the mechanical switching elements (22) are arranged on the vehicle steering wheel (10) offset in the peripheral direction (U).

9. The vehicle steering wheel according to either of claims 7 and 8, **characterized in that** the change-over switch (24) is arranged on a first steering wheel spoke (14) and the sensor surface (20) and the mechanical switching elements (22) are arranged on a second steering wheel spoke (14).

10. A method of operating a control element according to any of claims 1 to 5, **characterized in that** the sensor surface (20) and the mechanical switching elements (22) are selectively deactivated by actuating the change-over switch (24).

11. The method according to claim 10, **characterized in that** the deactivation can be cancelled in a time-dependent or function-dependent manner or manually.

## Revendications

1. Moyen de commande pour volant de véhicule (10), présentant une surface détectrice (20) fermée, tactile et formée de préférence de manière tridimensionnelle, au moins deux éléments de commutation mécaniques (22) qui sont agencés au-dessous de la surface détectrice (20) et qui sont aptes à être actionnés par déformation de la surface détectrice (20), la surface détectrice (20) tactile étant réalisée de manière si flexible que les éléments de commutation mécaniques (22) sont aptes à être actionnés individuellement, et présentant un inverseur (24) qui est apte à activer et/ou à désactiver les éléments de commutation mécaniques (22) et/ou la surface détectrice (20) tactile.

2. Moyen de commande selon la revendication 1, **caractérisé en ce que** les éléments de commutation mécaniques (22) sont des interrupteurs à faible course électriques.

3. Moyen de commande selon l'une des revendications 1 ou 2, **caractérisé en ce que** des éléments d'actionnement (28) qui actionnent les éléments de commutation mécaniques (22) sont prévus sur la face arrière (26) de la surface détectrice (20).

4. Moyen de commande selon l'une des revendications précédentes, **caractérisé en ce que** la surface détectrice (20) est réalisée au moins partiellement transparente ou translucide et **en ce qu'**il est prévu au moins une source lumineuse (36), en particulier une diode électroluminescente (38) qui est apte à illuminer la face arrière de la surface détectrice (20).

5. Moyen de commande selon l'une des revendications précédentes, **caractérisé en ce que** la surface détectrice (20) tactile est sensible au contact de façon capacitive.

6. Volant de véhicule (10) présentant un moyen de commande selon l'une des revendications précédentes, **caractérisé en ce que** le moyen de commande est agencé dans la zone des rayons (14) du volant et/ou de la jante (12) du volant.

7. Volant de véhicule selon la revendication 5, **caractérisé en ce que** l'inverseur (24) est agencé sur le volant de véhicule (10) séparément de la surface détectrice (20) et des éléments de commutation mécaniques (22).

8. Volant de véhicule selon la revendication 6, **caractérisé en ce que** l'inverseur (24) et la surface détectrice (20) présentant les éléments de commutation mécaniques (22) sont agencés sur le volant de véhicule (10) de manière décalée dans le sens périphérique (U).

9. Volant de véhicule selon l'une des revendications 7 et 8, **caractérisé en ce que** l'inverseur (24) est agencé sur un premier rayon (14) du volant et **en ce que** la surface détectrice (20) et les éléments de commutation mécaniques (22) sont agencés sur un deuxième rayon (14) du volant.

10. Procédé de mise en oeuvre d'un élément de commande selon l'une des revendications 1 à 5, **caractérisé en ce que** la surface détectrice (20) et les éléments de commutation mécaniques (22) sont sélectivement désactivés par actionnement de l'inverseur (24).

11. Procédé selon la revendication 10, **caractérisé en ce que** la désactivation est apte à être annulée en fonction du temps, du fonctionnement ou manuellement.
